Europäisches Patentamt

(19) **European Patent Office**

**Office européen des brevets**

(11) Publication number: **0 080 538**
**A1**

(12) **EUROPEAN PATENT APPLICATION**

(21) Application number: **81305609.0**

(22) Date of filing: **26.11.81**

(51) Int. Cl.³: **H 03 F 3/68**
**H 05 K 7/20, H 03 G 5/04**

(43) Date of publication of application:
**08.06.83 Bulletin 83/23**

(84) Designated Contracting States:
**AT BE CH DE FR IT LI LU NL SE**

(71) Applicant: **A.R.D. TECHNICAL ASSISTANCE AND**
**ENGINEERING SERVICES INTERNATIONAL ANSTALT**
**P.O. Box 34613**
**9490 , Vaduz(LI)**

(72) Inventor: **Gabr, Saad Zaghloul Mohamed**

**North Hatley Quebec(CA)**

(74) Representative: **Jones, Ian et al,**
**POLLAK MERCER & TENCH High Holborn House 52-54**
**High Holborn**
**London WC1V 6RY(GB)**

(54) **Amplifier printed circuit board and mounting system therefor.**

(57) An amplifier device comprises a plurality of amplifier printed circuit boards (10) having fixed thereto circuit means (14) for dividing an input signal into sub-signals of more limited frequency range and recombining the sub-signals after adjustment of the contribution each makes to the output. The board (10) or a plurality of like boards can be received in a channel member of conductive or non-conductive material (60, 70) and can be mounted directly or by way of the channel members in a support system comprising extended metal members (60, 70) forming a channel in which the boards can be associated with a mother board (78) or can extend across the channel which may be associated with lateral auxiliary channels.

FIG.1.

FIG.2.

Croydon Printing Company Ltd

-1-

AMPLIFIER PRINTED CIRCUIT BOARD AND MOUNTING SYSTEM
THEREFOR

DESCRIPTION

The invention relates to a printed circuit board, in particular to an amplifier circuit board, and to a support system for such a circuit board or other board.

In the production of audio amplifiers for domestic and commercial use, it is necessary for a manufacturer or supplier to be able to provide a variety of amplifier devices differing for example as to their power output. Amplifiers having different numbers of signal channels are also required, for example as between monophonic, stereophonic and quadrophonic systems. The range that must be made available is larger still where a single signal to be amplifier is subject to multi-channel processing, that is, where such a signal is divided into a plurality of sub-signals each extending over a respective portion only of the audio frequency range, which sub-signals are individually treated to control the contribution of each sub-signal to the complete output of the amplifier device. It is necessary also to provide mounting arrangements for the amplifiers which arrangements desirably provide adequate cooling and electric shielding facilities, as well as means for conveniently effecting connection to and any necessary interconnection between the amplifiers.

The invention accordingly provides an amplifier device having circuit means comprising an input for reception of an input signal extending over substantially the entire audio frequency range, a multisection filter for dividing the input signal into a plurality of sub-signals each having a respective frequency range less than that of the input signal, means for combining the sub-signals, amplifier means, and means for selective adjustment of the contribution of the sub-signals to the combined output signal, the circuit means being permanently received on a circuit board. At least one other like circuit board can be connected to such a board in parallel, so as to obtain a desired power output, so that from a small range of such boards, amplifiers having a variety of different specifications can be readily constructed from a relatively small number of pre-prepared parts. A manufacturer of amplifier devices can thus provide a wide range of amplifier devices of different specifications from only a small number of parts, many of which are common to all the amplifier devices of the range.

The invention thus provides a support system for printed circuit boards which functions as a universal construction and assembly system capable of incorporating an integrated heat sink, electrostatic shielding and electromagnetic shrouding. The printed circuit board support system of the invention can also eliminate the use of shielding wires within an amplifier or other device.

The support system can be light in weight, and of simple construction, to thereby reduce tooling and engineering costs, whilst providing improved heat dissipation.

The invention also provides a support system for one or more such printed circuit boards, the support system comprising a plurality of elongate members assembled together, a mother circuit board for supporting the circuit board or boards, the support
system being arranged to provide an electrostatic
shielding zone for the circuit board or boards.

The invention also provides an amplifier module
comprising a channel member of electrically
conductive or electrically non-conductive material
having a centre wall and parallel lateral walls, and
one or more such printed circuit boards received
therein to extend substantially parallel to the
lateral walls and to be spaced therefrom.  The
centre wall can be apertured and a mother board
received in the centre wall aperture, the circuit
board or boards being connected to the mother board.

The invention also provides a support system for
one or more printed circuit boards, the system
comprising a metal channel having a centre wall and
lateral walls, and means on the inner faces of the
lateral walls for receiving at least one circuit
board extending transversely of the channel between
the lateral walls.

The circuit board may be an amplifier circuit
board of the amplifier device of the invention,
received either directly in the system or by way of
the channel member when incorporated a module
described above.

The invention is further described below, by way
of example, with reference to the accompanying
drawings, in which:

Figure 1 is a schematic view of an amplifier
circuit board embodying the invention, with circuitry
shown thereon in block diagram form;

Figure 2 is a sectional end view of a first
support system in which amplifier circuit boards as
shown in Figure 1 are mounted;

Figure 3 is a like view of a second such support
system;  and

Figure 4 is a side view partially broken away, of a circuit board module in which a circuit board
as shown in Figure 1 is mounted, the module being received in the support system of Figure 3.

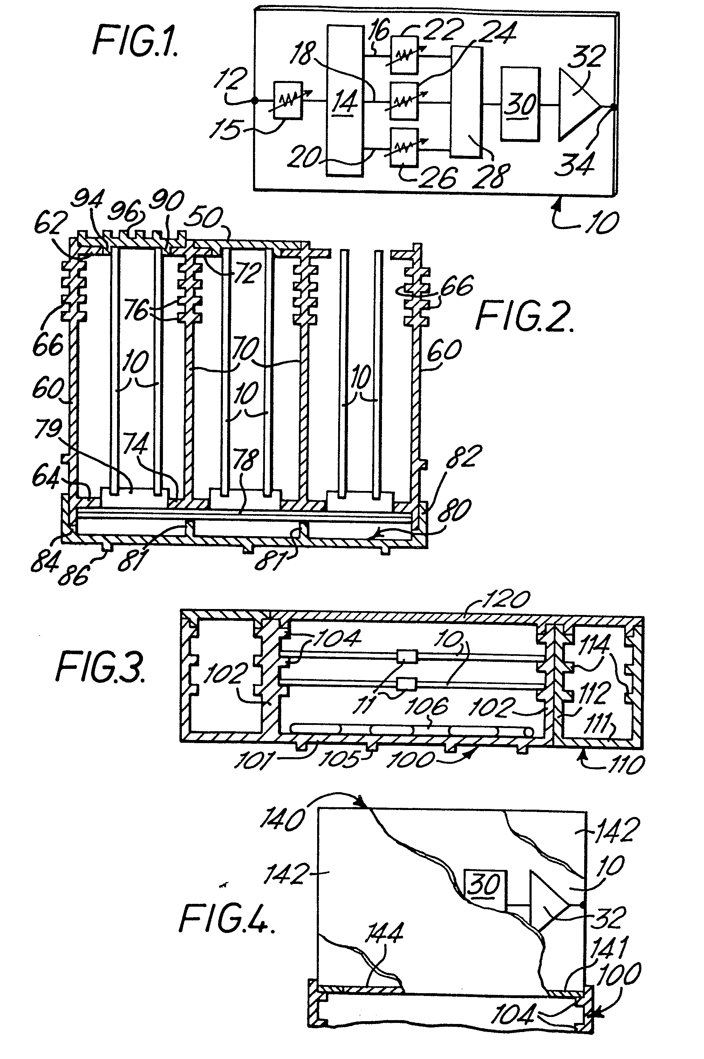

The amplifier circuit board of Figure 1 can be used in an audio amplifier construction system which comprises a plurality of such amplifier circuit boards of different characteristics from which a selection may be made in order to provide an amplifier of a desired specification. As schematically shown, the printed circuit board 10 comprises an input terminal or connection point 12 connected to a multisection filter 14, by which an input signal covering substantially the entire audio frequency range, say, between about 20 Hz and 20 kHz, is divided into three or other desired plurality of sub-signals each substantially confined to a respective narrower frequency range. A presettable control 15 at the input, so that the proportion of the input signal and amplitude which is applied to the filter 14 can be selectively adjusted. Each of the sub-signals is conveyed by a respective one of outputs 16,18,20 to a respective one of adjustable circuit elements 22,24,26. The circuit elements 22,24,26, which may be resistors, permit the amplitude of the respective sub-signal to be selectively adjusted. After any such adjustment the sub-signals are recombined into a single signal in a mixer 28.

This recombined signal can be conveyed to a compensation circuit 30 of the kind described in Specification GB 1 502 595. The compensated signal is supplied to a main amplifier unit 32 which provides an appropriate, and normally fixed, degree of amplification. The amplifier output is fed to one or more loudspeaker units by way of an output terminal 34 on the board.

The compensation circuit 30 compensates for nonlinearity in the response of the loudspeaker unit or units to which the terminal 34 is connected. Normally these are incapable of reproducing upper and lower frequencies at the same amplitude as frequencies in the middle range, and the circuit 20, which may be adjustable, is arranged to boost the upper and lower frequency parts of an incoming signal as compared with the middle frequency range, so that the loudspeaker sound output substantially accurately reproduces the amplitude level of the input signal over the entire frequency range.

The amplifier circuit board can be otherwise arranged. For example, a variable gain amplifier may be provided in each channel between the filter 14 and the mixer 28, instead of, or as well as the amplifier 32.

Four types of such amplifier circuit boards, differing in respect of number and relationship of the outputs provided by the multi-section filter, are preferably provided. The multisection filter of a first, basic, amplifier circuit board of the invention has a high pass filter, a low pass filter and a single band pass filter. The sub-signals into which the input signal is thereby divided of course together cover the entire audio frequency range, that is, the lowest frequency of the high pass channel is at least approximately the highest frequency of the band pass channel, whilst the upper frequency of the low pass channel is at least approximately the lowest frequency path of the band pass channel. A second such board comprises a multisection filter providing a low pass channel and three band pass channels, and a third board comprises a multisection filter with one high pass channel and four band pass channels. Finally, a fourth such amplifier circuit board provides four band pass channels.

The frequency ranges provided by the various channels of these amplifier boards are conveniently selected from the following list:

| 1. | below 40 Hz | 6. | 600 - 1200 Hz |
|---|---|---|---|
| 2. | 40 - 80 Hz | 7. | 1200 - 3 kHz |
| 3. | 80 - 160 Hz | 8. | 3 kHz - 6 kHz |
| 4. | 160 - 300 Hz | 9. | 6 kHz - 12 kHz |
| 5. | 300 - 600 Hz | 10. | over 12 kHz |

Thus, the first amplifier circuit board described may have its band pass channel providing an output in the frequency range of 300 Hz to 3 kHz, so that the high pass output is above 3 kHz and the low pass output below 300 Hz. For the other circuit boards, the frequency limits of the various channels are approximately chosen, to allow treatment of the entire audio frequency range by an appropriate selection of boards.

The invention also provides, for construction of an amplifier device, a support system for the circuit boards 10, comprising an assembly of elongate members, preferably cast or extruded metal members, for connection together to provide electrostatic shielding and/or a heat sink means for mother circuit boards on which the amplifier circuit boards can be mounted.

As shown in Figure 2, such an assembly comprises like outer side extrusions 60 and like inner extrusions 70. The outer extrusions have interiorly directed upper and lower flanges 62 and 64, and cooling ribs 66 on each side. The inner extrusions have upper and lower flanges 72 and 74 extending on both sides and ribs 76. A mother circuit board 78 is supported from the lower flanges 62,72 and is enclosed below by a shallow base extrusion 80 having upturned side flanges 82 and internal ridges 84 on which rest the lower ends of the side extrusions 60. The assembly can rest on a cabinet floor or other solid surface and external ribs 86 on the extrusion 80 provide space for cooling flow of air. An extrusion 90 spans the gap between the upper flanges 62,72 and provides locating shoulders for amplifier circuit boards 10 received below in connection blocks 79 on the board 78. The extrusion 90 has cooling ribs 96 on its upper surface and locating ribs 96 underneath for abutting the edges of the flanges 62,72.

The assembly on the left of Figure 2 provides a cooling system in which heat is caused to move in reverse direction to the natural convection currents of warm air, because of the temperature difference between the cooling channel formed by the extrusion 80 and the support surface, which may be apertured to promote air entry from outside. Hot air rising from the boards 10 heats the upper parts of the assembly and the heat is conducted downwardly by the extrusions 6 to the extrusion 80.

Where the heat produced by the circuit boards 10 is not so great as to require such cooling, the extrusion 90 can be replaced by an electrically non-conductive member 50 for example of plastics material as shown centrally of Figure 2, or omitted entirely as shown on the right. The extrusions 60,70 and 80 provided continue to act as a heat sink to some degree and provide adequate electrostatic shielding.

The amplifier 32 incorporated in the amplifier circuit boards 10 of the invention will normally be of non-adjustable gain, and the gain of the amplifiers on all the boards will be the same. The gain of the amplifier device can however be selected by arranging for it to include one of the or each circuit board or a plurality connected to operate in parallel. The support system described can receive a plurality of circuit boards each in a respective one of the channels between the extrusions 60,70 but where two of the amplifier circuit boards are employed in duplication to provide double the power output of one board alone, these two boards can be received together in a single channel, as shown in Figure 2.

Where a plurality of the amplifier circuit board is used to deal with a single input signal, a common input line can be provided to extend along the input ends of the channels formed by the support system to facilitate connection to each of the amplifier circuit boards, and where the outputs of the amplifier boards have to be combined, a common output line can be similarly arranged at the output ends of the channels.

A similar arrangement of power supply lines can be employed for the supply of power to the amplifier circuit boards. The power supplied to the boards may be at a voltage such that it can be applied directly to the circuit board components, but instead, each circuit board may incorporate its own power unit, a mains power supply being then connected to each board.

At a minimum, a single amplifier circuit board 10 of the first mentioned type can be mounted in the support system to constitute a monophonic amplifier device. More usually, at least one amplifier circuit board will be employed for each channel of a stereophonic system and frequently a plurality of the boards will be used for each channel to provide multi-channel processing of a desired fineness of control. Each board will be at least duplicated where this is needed to provide a required power output.

As shown in Figure 3, an alternative form of support system for the amplifier boards 10, in which the boards extend at least approximately horizontally in use, comprises a main cast or extruded metal channel member 100 having a centre wall or floor 101 and lateral or side walls 102, with a plurality of inwardly extending spaced parallel flanges 104 on each of the side walls 102. The flanges 104 on the side walls are transversely aligned and so provide a plurality of supports on or between which circuit boards, such as the amplifier circuit board 10, can be secured. These boards are provided with connector elements 11 at the positions of the input and output terminals 12,34 so that a plurality of the circuit boards received in adjacency on a single pair of the flanges 104 can be connected together directly in series. A plurality of circuit boards received in overlying relationship on different pairs of the flanges 104 can readily be connected in parallel by appropriate connector devices at their ends.

It will be evident that the channel member 100 provides electrostatic shielding for the circuit components on the circuit boards, and also a heat sink, with a channel between the lowermost circuit board and its floor 101, the undersurface of which can be provided with ridges 105 similar in function to the ridges 86 provided on the channel member 82 of Figure 2.

In addition, air or other fluid cooling means may be provided in the support system, for example, as shown in Figure 3, an array of tubing 106 be provided on the floor 101 of the main channel member 100 in good thermal contact therewith; the tubing can extend lengthwise of the member in parallel runs joined at alternate ends. Such an array can be duplicated if required or supplemented by a second array with runs extending transversely of the channel member. The ends of the tubing freely communicate with ambient atmosphere at positions which are preferably substantially vertically spaced. Heat from the amplifier circuit components collected by the heat sink arrangement of the support system promotes a convectional air flow through the tubing and thus a cooling effect. Such a cooling system provides a positive flow of air using only power derived from the waste heat which is to be removed.

The main channel member 100 can as shown be optionally associated with a similarly made auxiliary channel member 110 on one or on each side. The or each auxiliary channel member 110 has a floor 111 and walls 112 provided with transversely opposed pairs of internally projecting flanges 114, and may be integrally formed with the main channel as shown on the left of Figure 3 or secured thereto in an electrically conductive manner, as shown on the right. Ridges similar to the ridges 105 can be provided on the or each auxiliary channel member.

The or each auxiliary channel member 110 can be employed to contain a power line and one or more units also if required. Instead, the channel member 110 can be employed to receive an output line transformer where the system is being employed, for example, for a public address system. Another use for the auxiliary channels is for accommodating signal input and output lines, which may be in the form of printed circuit boards receiving on the flanges 114, and/or pre-amplifier and/or control means, and the outer walls of an auxiliary channel used for this purpose can then be apertured to provide for the mounting of variable resistor or another appropriate control units.

The main channel member 100 and/or any such auxiliary channel member 110 associated with it can be enclosed by a cover 120 as shown to complete the heat sink function of the system; the cover, as well as the main and auxiliary channel member can be provided with ridges or other formations on the external surfaces to enlarge the heat radiating area. The cover improves the electrostatic shielding but desirably does not form an electrically conductive path right around the circuit elements contained therein to avoid formation of a closed current path. The system, or appropriate parts of it, can be of iron and arranged to provide electro-magnetic shrouding of the electric circuit components contained therein if desired. The flanges 104 and 114 can be used not only to support printed circuit boards but also conductive members to divide the interiors of the channel members into separately shielded or shrouded chambers.

The system of Figure 3 requires no mother board, connections to and between the printed circuit boards being made by way of connector devices. The system offers a compact arrangement of which one dimension, the vertical dimension in the position shown, is particularly small compared with the others. The system can of course be employed in any orientation.

As shown in Figure 4, an amplifier circuit board module which can be assembled with the support system of Figure 3.

The circuit board module comprises a cast or extruded channel shaped member 140 having a centre or base wall 141 and lateral or side walls 142. Means is provided on the base wall 141 of the member 140 for supporting at least one circuit board 10 to extend generally parallel to the side walls 142. A plurality of the channel members can be received on the upper pair of inwardly projecting flanges 104 of the main channel member 100, with the side walls 142, and thus the or each circuit board contained between them, extending at right angles to the axis of the main channel member. The circuit boards preferably have their connecting terminals or other connecting devices located at the ends of the channel member 140 so connection can be made between them by means extending lengthwise of the main channel member.

In as far as the channel member 140 serves only to mount the circuit board or boards, it need not necessarily be of conductive material but could be of plastics material, particularly if the side walls of the channel member 100 extend higher than as indicated in Figure 4.

The base wall of the circuit board module can be apertured, so that connection can be made to the or each circuit board 10 by way of a mother board received on the flanges 104 of the main channel member 100.

In another modification, the apertured base wall of the channel member itself supports a mother board 144 to which is connected a circuit board 10 extending parallel to the side walls. This is convenient when the module contains more than one of the circuit boards 10. Connection between mother boards of adjacent modules can then be made within the channel formed by the circuit module base walls 141 and the floor of the main channel member 100.

It is evident that those skilled in the art may make numerous modifications of the specific embodiment described above without departing from the present inventive concepts. It is accordingly intended that the invention shall be construed as embracing each and every novel feature and novel combination of features present in or possessed by the apparatus herein described and that the foregoing disclosure shall be read as illustrative and not as limiting except to the extent set forth in the claims appended hereto.

CLAIMS

1. An amplifier device having circuit means comprising an input (12) for reception of an input signal extending over substantially the entire audio frequency range, a multisection filter (14) for dividing the input signal into a plurality of sub-signals each having a respective frequency range less than that of the input signal, means (28) for combining the sub-signals, amplifier means (32), and means (22,24,26) for selective adjustment of the contribution of the sub-signals to the combined output signal, characterised in that the circuit means are permanently received on a circuit board (10).

2. An amplifier device as claimed in claim 1 wherein the selective adjustment means (22,24,26) comprise separately adjustable elements located in circuit between the multisection filter (14) and the means (28) for combining the sub-signals.

3. An amplifier device as claimed in claim 1 or 2 wherein the amplifier means comprises a single amplifier (32) connected downstream of the means (28) for combining the sub-signals.

4. An amplifier device as claimed in claim 1, 2 or 3 having compensation means (30) for compensating a signal in the circuit board for non-linear response of a loudspeaker means to which the circuit board output is to be applied.

5. An amplifier device as claimed in claim 1, 2, 3 or 4 having a power unit received on the circuit board.

6. An amplifier device as claimed in any preceding claim wherein the amplifier circuit board (10) has at least one other like circuit board connected thereto in parallel to obtain a desired power output.

7. An amplifier device as claimed in any preceding claim having a support system for the circuit board or boards (10), the support system comprising a plurality of elongate members (60,70,80) assembled together, a mother circuit board (78) for supporting the circuit board or boards, the support system being arranged to provide an electrostatic shielding zone for the circuit board or boards.

8. An amplifier device as claimed in any one of claims 1 to 6 comprising a channel member of electrically conductive material or electrically non-conductive material having a centre wall (14) and parallel lateral walls (142), and the circuit board or boards (10) received therein to extend substantially parallel to the lateral walls and to be spaced therefrom.

9. An amplifier device as claimed in claim 8 wherein the centre wall (141) is apertured and a mother board (144) is received in the centre wall aperture, circuit board or boards (10) being connected to the mother board.

10. A support system for one or more printed circuit boards, the system comprising a metal channel (100) having a centre wall (101) and lateral walls (102), characterised by means (104) on the inner faces of the lateral walls for receiving at least one circuit board extending transversely of the channel between the lateral walls.

11. A support system as claimed in claim 17 wherein the means on the inner faces of the lateral walls (102) comprise a plurality of parallel longitudinally spaced flanges (104), each flange being parallel to a like flange on the other lateral wall and the flanges being equi-spaced from the centre wall (101).

12. A support system as claimed in claim 10 or 11 having an auxiliary metal channel extending along .one or both of the lateral walls, the or each electrically conductively connected with the channel.

13. A support system as claimed in claim 23 wherein the or each auxiliary channel has means (114) for supporting therein at least one elongate printed circuit board.

14. A support system as claimed in claim 10, 11, 12 or 13 having a cover for the channel and/or the auxiliary channel of electrically conductive or electrically non-conductive material.

15. A support system as claimed in any one of claims 10 to 14 having as the circuit board received therein the circuit board (10) of the amplifier device as claimed in any one of claims 1 to 6.

16. A support system as claimed in any one of claims 10 to 15 having as the circuit board received therein, the circuit board (10) of claim 8 or 9, with the walls (142) of the channel member extending transversely of the support system channel.

FIG.1.

FIG.2.

FIG.3.

FIG.4.

# EUROPEAN SEARCH REPORT

European Patent Office

| | **DOCUMENTS CONSIDERED TO BE RELEVANT** | | | CLASSIFICATION OF THE APPLICATION (Int. Cl. 3) |
|---|---|---|---|---|
| Category | Citation of document with indication, where appropriate, of relevant passages | Relevant to claim | | |
| X | US − A − 4 203 147 (S.Z.M. GABR) <br> * column 2, line 44 and the following; fig. 2, 5 * <br> & GB − A − 1 483 577 <br> & FR − A − 2 239 841 <br> & DE − A1 − 2 436 586 <br> −− | 1,7,9 | | H 03 F 3/68 <br> H 05 K 7/20 <br> H 03 G 5/04 |
| X | US − A − 4 118 601 (A.K.C. YEAP) <br> * fig. 1, 2 * <br> −− | 2,3 | | |
| A | FR − A − 2 197 302 (MERLIN GERIN) <br> * claim 1 * <br> −− | 14 | | **TECHNICAL FIELDS SEARCHED (Int.Cl. 3)** <br><br> H 03 F 3/181 <br> H 03 F 3/20 <br> H 03 F 3/68 <br> H 03 G 5/04 <br> H 05 K 7/20 |
| D,A | GB − A − 1 502 595 (A.R.D. ANSTALT) <br> * fig. 1 * <br> −− | | | |
| A | US − A − 3 848 092 (R.A. SHAMMA) <br> * fig. 11 * <br> −− | | | |
| A | US − A − 4 096 546 (S.Z.M. GABR) <br> * fig. 2 * <br> −− | | | |
| A | FUNKSCHAU, Vol. 52, No. 4, February 1980 München <br> H. Mondorf "Das Aktivboxen-Konzept AE 60-K" <br> pages 79 to 81 <br> * page 80; fig. 2 * <br> −−−− | | | |

The present search report has been drawn up for all claims

| Place of search | Date of completion of the search | Examiner |
|---|---|---|
| Berlin | 01-07-1982 | BREUSING |

EPO Form 1503.1   06.78